# EUROPÄISCHE PATENTSCHRIFT

(11) **EP 1 997 160 B1**
(45) Veröffentlichungstag und Bekanntmachung des Hinweises auf die Patenterteilung: **30.01.2013**
(21) Anmeldenummer: 07726665.8
(22) Anmeldetag: 07.03.2007
(51) Int. Cl.: H01L 41/293, H01L 41/335, H01L 41/083

(54) **PIEZOAKTOR UND VERFAHREN ZUM HERSTELLEN EINES PIEZOAKTORS**
PIEZOELECTRIC ACTUATOR AND METHOD FOR PRODUCING A PIEZOELECTRIC ACTUATOR
ACTIONNEUR PIÉZOÉLECTRIQUE ET PROCÉDÉ DE FABRICATION D'UN ACTIONNEUR PIÉZOÉLECTRIQUE

(30) Priorität: 10.03.2006 DE 102006011293
(43) Veröffentlichungstag der Anmeldung: 03.12.2008
(73) Patentinhaber: Continental Automotive GmbH, 30165 Hannover (DE)
(72) Erfinder: HEINZE, Thomas, 09212 Limbach-Oberfrohna (DE); LENK, Andreas, 01728 Bannewitz Ot Possendorf (DE)
(86) Internationale Anmeldenummer: PCT/EP2007/052107
(87) Internationale Veröffentlichungsnummer: WO 2007/104678

(56) Entgegenhaltungen:
- DE-A1- 10 041 338
- DE-A1- 10 042 893
- DE-A1- 10 042 941
- DE-A1-102004 012 033
- JP-A- 6 151 999
- US-A- 4 766 671
- HANSCH R ET AL: "The effects of the PbO content upon the microstructure and the ferroelectric properties of undoped sol-gel derived PZT(53/47) fibers" JOURNAL OF THE EUROPEAN CERAMIC SOCIETY, ELSEVIER SCIENCE PUBLISHERS, BARKING, ESSEX, GB, Bd. 24, Nr. 8, Juli 2004 (2004-07), Seiten 2485-2497, XP004490452 ISSN: 0955-2219

## Beschreibung

Die Erfindung betrifft einen Piezoaktor und Verfahren zum Herstellen eines Piezoaktors.

Piezoelemente werden u.a. für Positionierelemente, Ultraschallwandler, Sensoren und in Tintenstrahldruckern verwendet. Die Funktion eines Piezoelements beruht auf der Deformation piezokeramischer Materialien, wie z.B. Blei-Zirkonat-Titanat, unter Einwirkung eines elektrischen Feldes. Wird an das Piezoelement eine elektrische Spannung angelegt, so dehnt sich dieses in senkrechter Richtung zum von der elektrischen Spannung erzeugten elektrischen Feld aus.

Vorteile von Piezoelementen sind u.a. deren relativ große Geschwindigkeit, deren relativ große Effektivität und, wenn als Piezoaktor verwendet, deren relativ kleiner Stellweg.

Soll jedoch mit dem Piezoaktor ein relativ großer Stellweg erreicht werden, dann wird für den Piezoaktor ein Piezostapel aus mehreren abwechselnd aufeinanderfolgenden piezoelektrischen Schichten und Innenelektrodenschichten verwendet, wie dies z.B. in der JP 03174783 A offenbart ist.

Der in der JP 03174783 A offenbarte Piezoaktor ist derart ausgeführt, dass die Innenelektrodenschichten abwechselnd mit an gegenüberliegenden Außenflächen des Piezostapels angeordneten Außenelektroden elektrisch verbunden sind. Die Innenelektrodenschichten, die mit einer der beiden Außenelektroden elektrisch verbunden sind, sind daher bis zu der Außenseite, an der diese Außenelektrode angeordnet ist, für die elektrische Verbindung mit der Außenelektrode herangeführt. Damit die Innenelektrodenschichten jedoch von der anderen Außenelektrode elektrisch isoliert sind, reichen die Innenelektrodenschichten nicht bis zu der Außenseite des Piezostapels heran, an der die weitere Außenelektrode angeordnet ist. In diesen Bereichen sind die Innenelektrodenschichten von der Außenseite zurückgesetzt. Dies wird erreicht, indem der Piezostapel in diesen Bereichen mit Silikonharz gefüllten Schlitzen versehen ist.

Durch die zurückgesetzten Innenelektrodenschichten ergeben sich in den diesen Bereichen zugeordneten piezoelektrischen Schichten sogenannte inaktive Zonen, die bei einer an den Außenelektroden- bzw. Innenelektrodenschichten angelegten elektrischen Spannung von einer reduzierten elektrischen Feldstärke durchsetzt werden und sich daher bei angelegter elektrischer Spannung weniger stark dehnen als die übrigen sogenannten aktiven Zonen der piezoelektrischen Schichten. Dies führt zu mechanischen Spannungen insbesondere in den inaktiven Zonen und den Randbereichen zu den inaktiven Zonen und kann zu sogenannten Polungsrissen in den inaktiven und aktiven Zonen der piezoelektrischen Schichten, sowie in den Außenelektroden führen. Die Gefahr von Polungsrissen ist um so größer, je größer die inaktiven Zonen sind.

Üblicherweise werden die inaktiven Zonen bei der Schichtweisen Herstellung des Piezostapels erzeugt. Durch Toleranzen der Prozesse Stapeln, Trennen, Entbindern und Schleifen während der Herstellung des Piezostapels mit inaktiven Zonen und aufgrund der Vorgabe einer zuverlässigen elektrischen Isolierung der Innenelektrodenschichten zur entsprechenden Außenelektrode ergeben sich relativ große inaktive Zonen bis zu 10% des Piezostapelquerschnitts.

Die DE 10 2004 012 033 A1 beschreibt ein laminiertes piezoelektrisches Element, bei dem die Seitenflächen mit Elektroden und mit ausgesparten Nutenbereichen versehen sind, wobei die Nutenbereiche mit isolierendem Füllmaterial gefüllt sind.

Aus der DE 100 42 893 A1 ist ein laminiertes piezoelektrisches Stellglied mit an den Seitenoberflächen ausgebildeten Außenelektroden sowie mit piezoelektrischen Schichten und Innenelektrodenschichten bekannt, bei dem zwischen den Außenelektroden und den Elektrodenschichten teilweise Isolierblocks angeordnet sind.

Bei einem aus der DE 100 41 338 A1 bekannten Verfahren zum Herstellen eines keramischen Vielschichtbauelements wird ein aus mehreren Einzelschichten bestehender Grünkörper hergestellt, in den anschließend eine Anzahl von Löchern eingebracht wird. Der Grünkörper wird danach einem Entbinderungsschritt unterworfen und schließlich gesintert.

Die JP 06-151999 A beschreibt ein Herstellungsverfahren für einen laminierten piezoelektrischen Aktuator, bei dem in eine ungesinterte Grünfolie Löcher eingebracht werden, welche anschließend mit Isoliermaterial gefüllt werden.

Die Aufgabe der Erfindung ist es daher, ein Verfahren zum Herstellen eines Piezoaktors mit einem Piezostapel anzugeben, das es ermöglicht, den Piezostapel mit möglichst kleinen inaktiven Zonen herzustellen.

Die Aufgabe der Erfindung wird gelöst durch ein Verfahren zum Herstellen eines Piezoaktors mit einem Piezostapel und zwei an der Außenseite des Piezostapels angeordneten Außenelektroden, aufweisend folgende Verfahrensschritte:
- Bereitstellen eines vollaktiven Piezostapels aus mehreren abwechselnd aufeinanderfolgenden piezoelektrischen Schichten und durchgehenden Innenelektrodenschichten, die vorgesehen sind, abwechselnd mit zwei an der Außenseite des Piezostapels anzuordnenden Außenelektroden elektrisch verbunden und von der jeweiligen anderen Außenelektrode elektrisch isoliert zu sein,
- mittels eines Lasers oder eines Lasers kombiniert mit einem Galvoscanner, Versehen der Außenseite des vollaktiven Piezostapels mit Gräben in Bereichen, in denen die Innenelektrodenschichten von den entsprechenden Außenelektroden elektrisch isoliert sein sollen, sodass die Gräben die Innenelektrodenschichten in diesen Bereichen von der Außenseite des Piezostapels nach innen verkürzen,

- mittels des Lasers, Füllen der Gräben mit einem elektrisch isolierenden Material, wobei die Gräben mit dem Laser derart behandelt werden, dass diese durch Material im Bereich des jeweiligen Grabens zweier benachbarter piezoelektrischer Schichten geschlossen werden, und
- Aufbringen der beiden Außenelektroden auf die Außenseite des Piezostapels, sodass die beiden Außenelektroden abwechselnd mit den Innenelektrodenschichten elektrisch verbunden sind.

Das erfindungsgemäße Verfahren zum Herstellen eines Piezoaktors basiert darauf, dass ein vollaktiver Piezostapel weiter verarbeitet wird. Ein vollaktiver Piezostapel ist ein aus mehreren piezoelektrischen Schichten und dazwischen angeordneten elektrisch leitenden Schichten gebildeter Piezostapel. Die elektrisch leitenden Schichten bilden die Innenelektrodenschichten des Piezostapels und sind bei einem vollaktiven Piezostapel bis zu den Außenseiten des Piezostapels durchgehend ausgebildet. Ein vollaktiver Piezostapel hat demnach keine inaktiven, sondern nur aktive Zonen, d.h. eine zwischen zwei Innenelektrodenschichten angeordnete piezoelektrische Schicht des vollaktiven Piezostapels wird auf ihrer einen Seite von der einen Innenelektrodenschicht und auf ihrer anderen Seite von der anderen Innenelektrodenschicht komplett abgedeckt. Ein Vorteil eines vollaktiven Piezostapels ist dessen relativ einfache Herstellung mittels bekannter Prozessschritte, wie Stapeln, Trennen, Entbindern und Schleifen.

Die Innenelektrodenschichten sind dafür vorgesehen, abwechselnd mit an der Außenseite des Piezostapels anzuordnenden Außenelektroden elektrisch verbunden zu werden. Damit die Innenelektrodenschichten jedoch nur mit der für sie vorgesehene Außenelektrode elektrisch verbunden werden und von der anderen Außenelektrode elektrisch isoliert bleiben, werden die Bereiche der Außenseite, an der die weitere Außenelektrode später angeordnet wird, mit den Gräben versehen. Durch die Gräben werden die Innenelektrodenschichten in diesen Bereichen von der jeweiligen Außenseite des vollaktiven Piezostapels zurückversetzt, wodurch in diesen Bereichen inaktive Zonen entstehen. Damit beim späteren Anbringen der Außenelektroden die Innenelektrodenschichten auch nur mit der vorgesehenen Außenelektrode elektrisch verbunden werden, werden die Gräben vor dem Anbringen der Außenelektroden mit einem elektrisch isolierenden Material gefüllt.

Durch das erfindungsgemäße Versehen des vollaktiven Piezostapels mit den Gräben können die Gräben und somit die inaktiven Zonen des mit den Gräben versehenen Piezostapels relativ einfach derart dimensioniert sein, dass sie nicht größer sind, als es unbedingt für eine gute elektrische Isolierung der Innenelektrodenschichten zur entsprechenden Außenelektrode notwendig ist. Dadurch können die inaktiven Zonen dieses Piezostapels möglichst klein ausgeführt werden, wodurch die Gefahr der Entstehung von Polungsrissen zumindest vermindert wird. Um die inaktiven Zonen möglichst klein zu halten, haben die Gräben daher bevorzugt eine Tiefe, Breite und/ oder Höhe, die gerade ausreicht, um die Innenelektrodenschichten von der gewünschten Außenelektrode elektrisch zu isolieren.

Die Gräben werden mit einem Laser und insbesondere in Verbindung mit einem Galvoscanner hergestellt. Der Laser ist z.B. ein ps-Laser. Mit einem solchen Laser ist es besonders gut möglich, die Gräben selektiv abzutragen, wodurch diese möglichst klein ausfallen. Außerdem ist der Laser auch dafür vorgesehen, die Gräben in einem weiteren Prozessschritt mit dem elektrisch isolierenden Material zu füllen. So ist es z.B. möglich, die Gräben mit während des Herstellens der Gräben mit dem Laser entstandenen Ablationsprodukten wieder zu füllen. Des Weiteren hat ein Laser den Vorteil, dass durch eine geeignete Laserparametrierung das Material der piezoelektrischen Schichten und der Innenelektrodenschichten für die Gräben relativ schonend für den restlichen Piezostapel abgetragen werden.

Die Gräben werden vor dem Auftragen der Außenelektroden mit dem Laser derart behandelt, dass diese durch Material im Bereich des jeweiligen Grabens zweier benachbarter piezoelektrischen Schichten geschlossen werden. Dieser Prozessschrittlässt sich z.B. dadurch erreichen, dass der Laser beim Herstellen der Gräben mit einer ersten Laserparametrierung und für das Verschließen der Gräben mit einer zweiten Laserparametrierung über die Außenseite des Piezostapels geführt wird. Alternativ ist es erfindungsgemäß auch vorgesehen, nicht den vollaktiven Piezostapel, sondern einen vollaktiven Grünstapel mit den Gräben zu versehen. Unter einem vollaktiven Grünstapel versteht man dabei einen verpressten Stapel aus mehreren Grünfolien und dazwischen angeordneten elektrisch leitenden Schichten. Die Grünfolien werden aus einem sogenannten Schlicker hergestellt. Der Schlicker ist ein flüssiges Gemisch aus Keramikpulver und Bindern. Die elektrisch leitenden Schichten bilden die Innenelektrodenschichten des aus dem Grünstapel herzustellenden Piezostapels und sind bei einem vollaktiven Grünstapel analog zum vollaktiven Piezostapel bis zu den Außenseiten des Grünstapels durchgehend ausgebildet. Durch die Prozessschritte Entbindern und Sintern entstehen aus den Grünfolien piezoelektrische Schichten, d.h. durch das Entbindern und Sintern entsteht aus dem vollaktiven Grünstapel ein vollaktiver Piezostapel. Erfindungsgemäß ist es nun alternativ vorgesehen, den vollaktiven Grünstapel mit den Gräben zu versehen und den mit den Gräben versehenen Grünstapel zu Entbindern und zu Sintern, sodass aus den Schlickerschichten piezoelektrische Schichten werden. Der so entstandene Piezostapel mit Gräben wird dann, wie obenstehend beschrieben, weiter verarbeitet, d.h. es werden die Gräben mit dem elektrisch isolierenden Material gefüllt und die beiden Außenelektroden auf die Außenseite des Piezostapels aufgetragen.

Ausführungsbeispiele der Erfindung sind in den beigefügten schematischen Zeichnungen beispielhaft dargestellt. Es zeigen:
- Figur 1: einen vollaktiven Piezostapel,
- Figur 2 und 3: einen aus dem in der Fig. 1 gezeigten Piezostapel hergestellten Piezoaktor,
- Figur 4: einen mit Gräben versehenen Piezostapel, der aus dem in der Figur 1 dargestellten vollaktiven Piezostapel hergestellt wird,
- Figur 5: einen Graben des Piezostapels der Figur 4,
- Figur 6: den Piezostapel der Figur 4 mit gefüllten Gräben,
- Figur 7: einen weiteren Piezoaktor,
- Figur 8: einen Prozessschritt zur Herstellung des in der Figur 7 gezeigten Piezoaktors,
- Figur 9: einen vollaktiven Grünstapel und
- Figur 10: einen mit Gräben versehener Grünstapel.

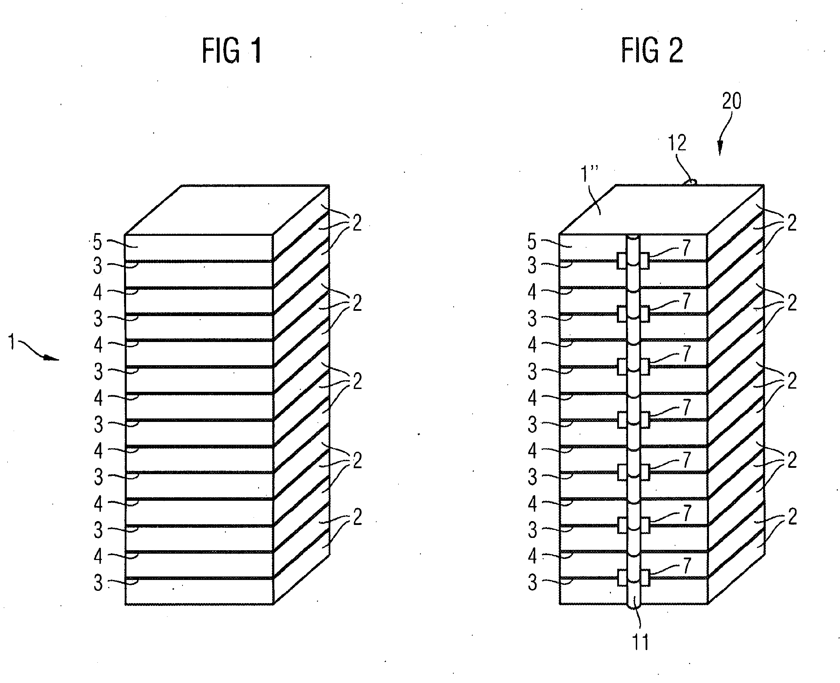

Die Figur 1 zeigt einen quaderförmig ausgeführten vollaktiven Piezostapel 1, der mehrere piezoelektrische Schichten 2 und mehrere dazwischen angeordnete Innenelektroden 3, 4 aufweist und in allgemein bekannter Weise, beispielsweise durch die Prozessschritte Stapeln, Trennen, Entbindern und Schleifen erzeugt wurde. Die piezoelektrischen Schichten 2 umfassen ein piezokeramisches Material, im Falle des vorliegenden Ausführungsbeispieles Blei-Zirkonat-Titanat und bei den Innenelektroden 3, 4 handelt es sich im Falle des vorliegenden Ausführungsbeispiels um elektrisch leitfähige Metallschichten, die den vollaktiven Piezoaktor 1 durchgehend durchsetzen, also bis an die Außenseiten des Piezostapels 1 durchgehend ausgebildet sind, sodass der vollaktive Piezostapel 1 keine inaktiven, sondern nur aktive Zonen hat.

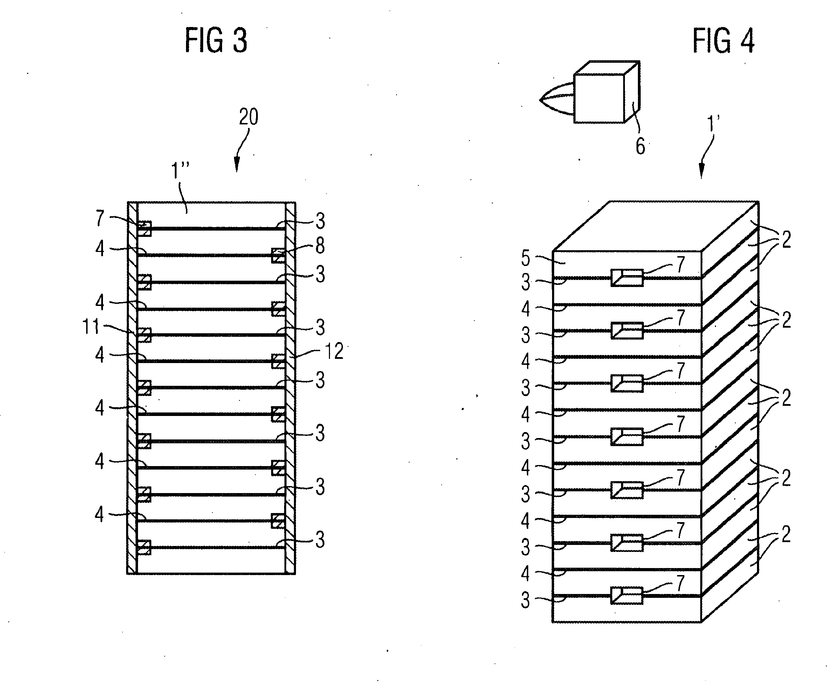

Der vollaktive Piezostapel 1 wird für die Herstellung eines in den Figuren 2 und 3 gezeigten Piezoaktors 20 verwendet, wobei die Figur 3 den Piezoaktor 20 in geschnittener Darstellung zeigt.

Zur Herstellung des Piezoaktors 20 wird zunächst mit einem in der Figur 4 gezeigten Laser 6 eine der Außenseiten 5 des Piezostapels 1 mit Gräben 7 und die der Außenseite 5 gegenüberliegenden Außenseite mit in der Figur 3 gezeigten Gräben 8 versehen, sodass aus dem vollaktiven Piezostapel 1 ein in der Figur 4 dargestellter Piezostapel 1' entsteht.

Die Außenseite 5 des Piezostapels 1' ist derart mit den Gräben 7 versehen, dass jede zweite Innenelektrode durch die Gräben 7 in das Innere des Piezostapels 1' zurückversetzt ist und die übrigen Innenelektroden vollständig an die Außenseite 5 herangeführt bleiben. Die Gräben 8 der der Außenseite 5 gegenüberliegenden Außenseite sind derart ausgeführt, dass sie jeweils die übrigen Innenelektroden in das Innere des Piezostapels 1' zurückversetzten. Im Falle des vorliegenden Ausführungsbeispiels sind die Gräben 7 der Außenseite 5 den Innenelektroden 3 und die Gräben 8 der der Außenseite 5 gegenüberliegenden Außenseite den Innenelektroden 4 zugeordnet.

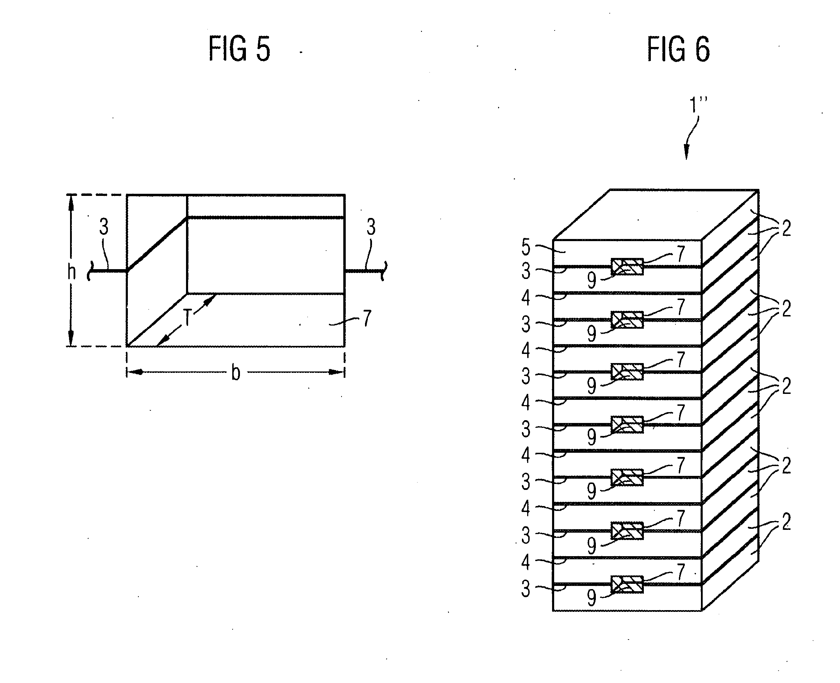

Die Gräben 7, 8 werden mit dem Laser 6 derart hergestellt, dass dieser entsprechendes Material der Innenelektroden 3 bzw. der Innelektroden 4 und der daran angrenzenden piezoelektrischen Schichten 2 abträgt. Jeder der Gräben 7, von denen einer in der Figur 5 näher dargestellt ist, hat eine Tiefe T, eine Breite b und eine Höhe h. Die Gräben 8 haben dieselben Abmessungen, es werden jedoch Bereiche der Innenelektroden 4 um die Tiefe T in das Innere des Piezostapels 1' versetzt.

Anschließend werden die Gräben 7, 8 mit einem elektrisch isolierenden Material 9 befüllt, das im Falle des vorliegenden nicht-erfindungsgemäßen Beispiels ein Zweikomponenten-Silikon ist, das eine Stunde bei 150 °C ausgehärtet wird. Dadurch entsteht der in der Figur 6 gezeigte Piezostapel 1".

Anschließend wird die Außenseite 5 mit einer in der Figur 2 gezeigten Außenelektrode 11 versehen, welche als Außenmetallisierung längs der Außenseite 5 des Piezostapels 1" aufgetragen wird. Die Außenelektrode 11 wird durch das Auftragung der Außenmetallisierung elektrisch mit den Innenelektroden 4 verbunden. Die Außenelektrode 11 ist außerdem schmäler als die Gräben 7 breit sind und verläuft über die mit dem elektrisch isolierenden Material 9 gefüllten Gräben 7, sodass die Außenelektrode 11 von den Innenelektroden 3 elektrisch isoliert ist. Im Falle des vorliegenden Beispiels sind außerdem die Tiefe T, die Breite b und die Höhe h der Gräben 7 derart gewählt, dass sie in Verbindung mit dem elektrisch isolierenden Material 9 eine zuverlässige elektrische Isolierung der Innenelektroden 3 von der Außenelektrode 11 gewährleisten.

Die der der Außenseite 5 gegenüberliegenden Außenseite des Piezostapels 1' wird mit einer in der Figur 3 gezeigten weiteren Außenelektrode 12 in Form einer weiteren Außenmetallisierung versehen. Die Außenelektrode 12 kontaktiert die Innenelektroden 3 und verläuft längs des Piezostapels 1" über die Gräben 8. Die Außenelektrode 12 ist schmäler als die Gräben 8 breit sind. Dadurch ist gewährleistet, dass die Außenelektrode 12 von den Innenelektroden 4 elektrisch isoliert sind.

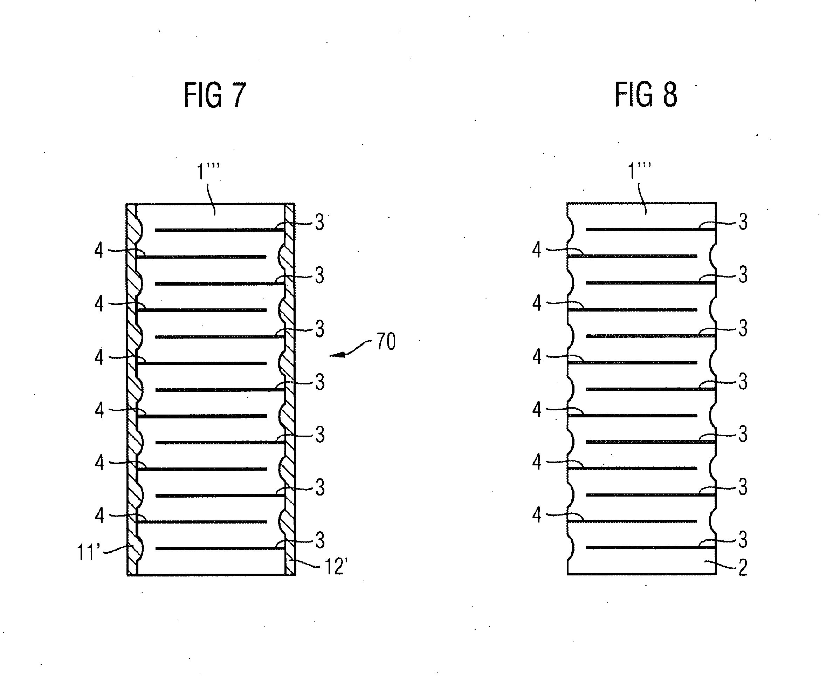

Die Figur 7 zeigt einen erfindungsgemäßen Piezoaktor 70, der ebenfalls aus einem vollaktiven Piezostapel 1 hergestellt wird. Im Gegensatz zu dem in der Figur 6 dargestellten Piezostapel 1" werden jedoch für die Herstellung des Piezoaktors 70 die Gräben 7, 8 des Piezostapels 1' nicht mit dem elektrisch isolierenden Material 9 gefüllt, sondern mit dem Laser 6 verschlossen, sodass ein in der Figur 8 dargestellte Piezostapel 1"' entsteht. Für das Verschließen der Gräben 7, 8 wird die Parameter-Einstellung des Lasers 6 geändert und der Laser 6 über die Gräben 7, 8 gefahren. Die Parameter-Einstellung des Lasers 6 ist derart gewählt, dass die piezoelektrischen Schichten 2 aufgrund der Behandlung der Außenseite 5 bzw. der der Außenseite 5 gegenüberliegenden Außenseite die Gräben 7, 8 mit Material der piezoelektrischen Schichten 2 verschließen.

Anschließend wird der Piezostapel 1'" mit Außenelektroden 11', 12' versehen, wobei die Außenelektrode 11' die Innenelektrodenschichten 4 und die Außenelektrode 12' die Innenelektroden 3 kontaktieren.

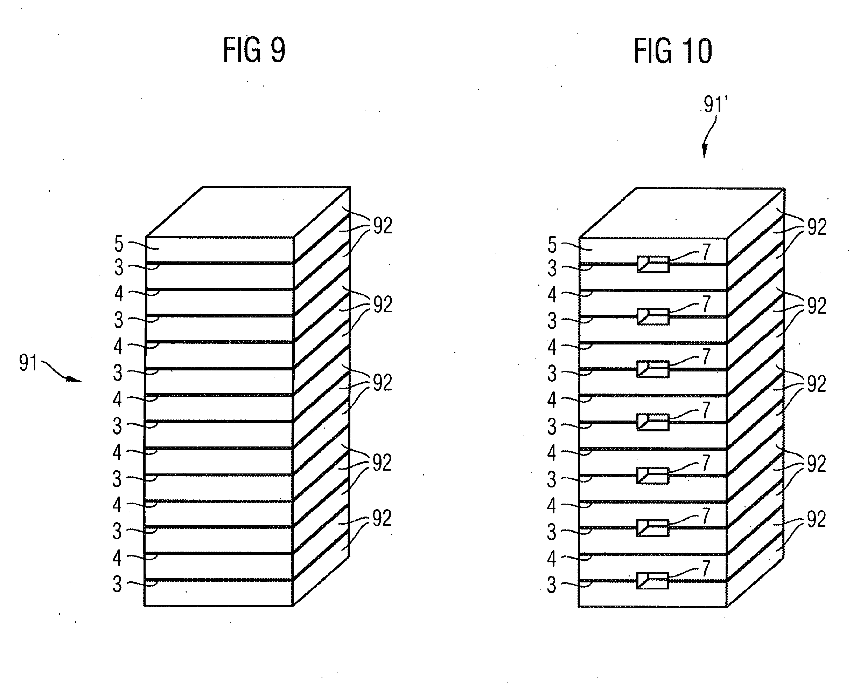

Für die in den Figuren 2, 3 und 7 gezeigten Piezoaktoren 20, 70 wurde jeweils der vollaktiver Piezostapel 1 mit den Gräben 7, 8 versehen. Alternativ ist es auch möglich, zunächst einen in der Fig. 9 gezeigten vollaktiven Grünstapel 91 mit den Gräben 7, 8 zu versehen, sodass ein in der Fig. 10 gezeigter Grünstapel 91' entsteht.

Unter einem vollaktiven Grünstapel 91 versteht man dabei einen Stapel aus mehreren Schlickerschichten 92 und dazwischen angeordneten elektrisch leitenden Schichten. Der Schlicker der Schlickerschichten 92 ist ein Keramikpulver mit Bindern und ist im Wesentlichen flüssig. Die elektrisch leitenden Schichten bilden die Innenelektroden 3, 4 des aus dem Grünstapel 91 herzustellenden Piezostapels und sind bei einem vollaktiven Grünstapel 91 analog zum vollaktiven Piezostapel 1 bis zu den Außenseiten des Grünstapels 91 durchgehend ausgebildet. Durch die Prozessschritte Entbindern und Sintern entstehen aus den Schlickerschichten piezoelektrische Schichten 2, d.h. durch das Entbindern und Sintern entsteht aus dem vollaktiven Grünstapel 91 z.B. der vollaktive Piezostapel 1.

Der in der Fig. 10 dargestellte und mit den Gräben 7, 8 versehene Grünstapel 91' wird im Falle des vorliegenden Ausführungsbeispiels entbindert und gesintert, sodass aus den Schlickerschichten 92 piezoelektrische Schichten entstehen und somit aus dem mit den Gräben 7, 8 versehenen Grünstapel 91' ein mit Gräben 7, 8 versehener Piezostapel entsteht, der dem in der Fig. 4 gezeigten Piezostapel 1' entspricht. Dieser Piezostapel wird, wie obenstehend beschrieben, weiter verarbeitet, bis der Piezoaktor 20 oder 70 entsteht.

## Patentansprüche

1. Verfahren zum Herstellen eines Piezoaktors (20, 70) mit einem Piezostapel (1" , 1''') und zwei an der Außenseite (5) des Piezostapels (1'', 1''') angeordneten Außenelektroden (11, 12, 11', 12'), aufweisend folgende Verfahrensschritte:
- Bereitstellen eines vollaktiven Piezostapels (1) aus mehreren abwechselnd aufeinanderfolgenden piezoelektrischen Schichten (2) und durchgehenden Innenelektrodenschichten (3, 4), die vorgesehen sind, abwechselnd mit zwei an der Außenseite (5) des Piezostapels (1) anzuordnenden Außenelektroden (11, 12, 11', 12') elektrisch verbunden und von der jeweiligen anderen Außenelektrode (11, 12, 11', 12') elektrisch isoliert zu sein,
- mittels eines Lasers (6) oder eines Laser kombiniert mit einem Galvoscanner, Versehen der Außenseite (5) des vollaktiven Piezostapels (1) mit Gräben (7, 8) in Bereichen, in denen die Innenelektrodenschichten (3, 4) von den entsprechenden Außenelektroden (11, 12, 11', 12') elektrisch isoliert sein sollen, sodass die Gräben (7, 8) die Innenelektrodenschichten (3, 4) in diesen Bereichen von der Außenseite (5) des Piezostapels (1) nach innen verkürzen,
- mittels des Lasers (6), Füllen der Gräben (7, 8) mit einem elektrisch isolierenden Material (9), wobei die Gräben (7, 8) mit dem Laser (6) derart behandelt werden, dass diese durch Material im Bereich des jeweiligen Grabens (7, 8) zweier benachbarter piezoelektrischer Schichten (2) geschlossen werden, oder Füllen der Gräben (7, 8) mit Ablationsprodukten, die während der Herstellung der Gräben (7, (7, 8) mittels des Lasers (6) entstehen, und
- Aufbringen der beiden Außenelektroden (11, 12, 11', 12') auf die Außenseite (5) des Piezostapels (1", 1"'), sodass die beiden Außenelektroden (11, 12, 11', 12') abwechselnd mit den Innenelektrodenschichten (3, 4) elektrisch verbunden sind.

2. Verfahren zum Herstellen eines Piezoaktors (20, 70) mit einem Piezostapel (1" , 1"') und zwei an der Außenseite (5) des Piezostapels (1", 1"') angeordneten Außenelektroden (11, 12, 11', 12'), aufweisend folgende Verfahrensschritte:
- Bereitstellen eines vollaktiven Grünstapels (91) aus mehreren abwechselnd aufeinanderfolgenden Grünfolien (92) und durchgehenden Innenelektrodenschichten (3, 4), die vorgesehen sind, abwechselnd mit zwei an der Außenseite (5) des aus dem Grünstapel (91) herzustellenden Piezostapels (1'', 1"') anzuordnenden Außenelektroden (11, 12, 11', 12') elektrisch verbunden und von der jeweiligen anderen Außenelektrode (11, 12, 11', 12') elektrisch isoliert zu sein,
- mittels eines Lasers (6) oder eines Laser kombiniert mit einem Galvoscanner, Versehen der Außenseite (5) des vollaktiven Grünstapels (91) mit Gräben (7, 8) in Bereichen, in denen die Innenelektrodenschichten (3, 4) von den entsprechenden Außenelektroden (11, 12, 11', 12') elektrisch isoliert sein sollen, sodass die Gräben (7, 8) die Innenelektrodenschichten (3, 4) in diesen Bereichen von der Außenseite (5) des Grünstapels (91) nach innen verkürzen,
- Weiterverarbeiten des mit den Gräben (7, 8) versehenen Grünstapels (91') derart, dass aus den Grünfolien (92) piezoelektrische Schichten (2) werden und somit aus dem Grünstapel (91') ein Piezostapel (1" , 1"') wird,
- mittels des Lasers, Füllen der Gräben (7, 8) mit einem elektrisch isolierenden Material (9), wobei die Gräben (7, 8) mit dem Laser (6) derart behandelt werden, dass diese durch Material im Bereich des jeweiligen Grabens (7, 8) zweier benachbarter piezoelektrischer Schichten (2) geschlossen werden,
- Aufbringen der beiden Außenelektroden (11, 12, 11', 12') auf die Außenseite (5) des Piezostapels (1'', 1"'), sodass die beiden Außenelektroden (11, 12, 11', 12') abwechselnd mit den Innenelektrodenschichten (3, 4) elektrisch verbunden sind.

3. Verfahren nach Anspruch 1 oder 2, bei dem die Gräben (7, 8) eine Tiefe (T), Breite (b) und/oder Höhe (h) aufweisen, die gerade nötig für eine elektrische Isolation der Innenelektrodenschichten (3, 4) zur entsprechenden Außenelektrode (11, 12) ist.

4. Verfahren nach Anspruch 1 bis 3, bei dem die Gräben (7, 8) mittels selektivem Laser-Abtragens hergestellt werden.

5. Piezoaktuator mit einem Piezostapel (1" , 1''') und zwei an der Außenseite (5) des Piezostapels (1" , 1"') angeordneten Außenelektroden, der gemäß dem Verfahren nach einem der Ansprüche 1 bis 4 hergestellt wurde.

## Claims

1. Method for producing a piezo-actuator (20, 70) comprising a piezo-stack (1", 1"') and two external electrodes (11, 12, 11', 12') arranged on the outer side (5) of the piezo-stack (1", 1"'), comprising the following method steps:
- providing a fully active piezo-stack (1) composed of a plurality of alternately successive piezoelectric layers (2) and continuous internal electrode layers (3, 4), which are provided for being alternately electrically connected to two external electrodes (11, 12, 11', 12') to be arranged on the outer side (5) of the piezo-stack (1), and electrically insulated from the respective other external electrode (11, 12, 11', 12'),
- by means of a laser (6) or a laser combined with a galvoscanner, providing the outer side (5) of the fully active piezo-stack (1) with trenches (7, 8) in regions in which the internal electrode layers (3, 4) are intended to be electrically insulated from the corresponding external electrodes (11, 12, 11', 12'), such that the trenches (7, 8) shorten the internal electrode layers (3, 4) in these regions from the outer side (5) of the piezo-stack (1) inwards,
- by means of the laser (6), filling the trenches (7, 8) with an electrically insulating material (9), wherein the trenches (7, 8) are treated with the laser (6) in such a way that they are closed by material in the region of the respective trench (7, 8) of two adjacent piezoelectric layers (2), or filling the trenches (7, 8) with ablation products that arise during the production of the trenches (7, 8) by means of the laser (6), and
- applying the two external electrodes (11, 12, 11', 12') to the outer side (5) of the piezo-stack (1", 1"'), such that the two external electrodes (11, 12, 11', 12') are alternately electrically connected to the internal electrode layers (3, 4).

2. Method for producing a piezo-actuator (20, 70) comprising a piezo-stack (1", 1"') and two external electrodes (11, 12, 11', 12') arranged on the outer side (5) of the piezo-stack (1", 1"'), comprising the following method steps:
- providing a fully active green stack (91) composed of a plurality of alternately successive green sheets (92) and continuous internal electrode layers (3, 4), which are provided for being alternately electrically connected to two external electrodes (11, 12, 11', 12') to be arranged on the outer side (5) of the piezo-stack (1", 1''') to be produced from the green stack (91), and electrically insulated from the respective other external electrode (11, 12, 11', 12'),
- by means of a laser (6) or a laser combined with a galvoscanner, providing the outer side (5) of the fully active green stack (91) with trenches (7, 8) in regions in which the internal electrode layers (3, 4) are intended to be electrically insulated from the corresponding external electrodes (11, 12, 11', 12'), such that the trenches (7, 8) shorten the internal electrode layers (3, 4) in these regions from the outer side (5) of the green stack (91) inwards,
- further processing the green stack (91') provided with the trenches (7, 8) in such a way that the green sheets (92) become piezoelectric layers (2) and the green stack (91') thus becomes a piezo-stack (1", 1'"),
- by means of the laser (6), filling the trenches (7, 8) with an electrically insulating material (9), wherein the trenches (7, 8) are treated with the laser (6) in such a way that they are closed by material in the region of the respective trench (7, 8) of two adjacent piezoelectric layers (2), and
- applying the two external electrodes (11, 12, 11', 12') to the outer side (5) of the piezo-stack (1", 1"'), such that the two external electrodes (11, 12, 11', 12') are alternately electrically connected to the internal electrode layers (3, 4).

3. Method according to Claim 1 or 2, wherein the trenches (7, 8) have a depth (T), width (b) and/or height (h) which are/is precisely necessary for an electrical insulation of the internal electrode layers (3, 4) from the corresponding external electrode (11, 12).

4. Method according to Claims 1 to 3, wherein the trenches (7, 8) are produced by means of selective laser removal.

5. Piezo-actuator comprising a piezo-stack (1", 1"') and two external electrodes arranged on the outer side (5) of the piezo-stack (1", 1"'), which piezo-actuator was produced in accordance with the method according to any of claims 1 to 4.

## Revendications

1. Procédé de fabrication d'un actionneur piézoélectrique (20, 70) avec un empilement piézoélectrique (1", 1"') et deux électrodes extérieures (11, 12, 11', 12') agencées contre le côté extérieur (5) de l'empilement piézoélectrique (1", 1"'), comprenant les étapes de procédé consistant à :
- préparer un empilement piézoélectrique (1) totalement actif à partir d'une succession alternée de plusieurs couches piézoélectriques (2) et couches d'électrodes intérieures continues (3, 4), qui sont prévues pour être, alternativement, électriquement reliées à deux électrodes extérieures (11, 12, 11', 12') à agencer contre le côté extérieur (5) de l'empilement piézoélectrique (1), et électriquement isolées de l'autre électrode extérieure respective (11, 12, 11', 12'),
- au moyen d'un laser (6) ou d'un laser combiné à un scanner galvanométrique, doter le côté extérieur (5) de l'empilement piézoélectrique (1) totalement actif de tranchées (7, 8) dans les régions dans lesquelles les couches d'électrodes intérieures (3, 4) doivent être isolées électriquement des électrodes extérieures correspondantes (11, 12, 11', 12'), de sorte que dans ces régions les tranchées (7, 8) raccourcissent les couches d'électrodes intérieures (3, 4) depuis le côté extérieur (5) de l'empilement piézoélectrique (1) vers l'intérieur,
- au moyen du laser (6), remplir les tranchées (7, 8) d'un matériau électriquement isolant (9), où les tranchées (7, 8) sont traitées par le laser (6) de telle sorte qu'elles sont fermées par du matériau dans la région de la tranchée respective (7, 8) de deux couches piézoélectriques voisines (2), ou remplir les tranchées (7, 8) de produits d'ablation qui sont obtenus lors de la réalisation des tranchées (7, 8) au moyen du laser (6), et
- mettre en place les deux électrodes extérieures (11, 12, 11', 12') sur le côté extérieur (5) de l'empilement piézoélectrique (1", 1"'), de sorte que les deux électrodes extérieures (11, 12, 11', 12') sont alternativement électriquement reliées aux couches d'électrodes intérieures (3, 4).

2. Procédé de fabrication d'un actionneur piézoélectrique (20, 70) avec un empilement piézoélectrique (1", 1"') et deux électrodes extérieures (11, 12, 11', 12') agencées contre le côté extérieur (5) de l'empilement piézoélectrique (1", 1"'), comprenant les étapes de procédé consistant à :
- préparer un empilement vert (91) totalement actif à partir d'une succession alternée de plusieurs feuilles vertes (92) et couches d'électrodes intérieures continues (3, 4), qui sont prévues pour être, alternativement, électriquement reliées à deux électrodes extérieures (11, 12, 11', 12') à agencer contre le côté extérieur (5) de l'empilement piézoélectrique (1) à fabriquer à partir de l'empilement vert (91), et électriquement isolées de l'autre électrode extérieure respective (11, 12, 11', 12'),
- au moyen d'un laser (6) ou d'un laser combiné à un scanner galvanométrique, doter le côté extérieur (5) de l'empilement vert (91) totalement actif de tranchées (7, 8) dans les régions dans lesquelles les couches d'électrodes intérieures (3, 4) doivent être isolées électriquement des électrodes extérieures correspondantes (11, 12, 11', 12'), de sorte que dans ces régions les tranchées (7, 8) raccourcissent les couches d'électrodes intérieures (3, 4) depuis le côté extérieur (5) de l'empilement vert (91) vers l'intérieur,
- poursuivre le traitement de l'empilement vert (91') doté des tranchées (7, 8) de telle sorte que les feuilles vertes (92) deviennent des couches piézoélectriques (2) et qu'ainsi l'empilement vert (91) devient un empilement piézoélectrique (1", 1"'),
- au moyen du laser, remplir les tranchées (7, 8) d'un matériau électriquement isolant (9), où les tranchées (7, 8) sont traitées par le laser (6) de telle sorte qu'elles sont fermées par du matériau dans la région de la tranchée respective (7, 8) de deux couches piézoélectriques voisines (2),
- mettre en place les deux électrodes extérieures (11, 12, 11', 12') sur le côté extérieur (5) de l'empilement piézoélectrique (1", 1"'), de sorte que les deux électrodes extérieures (11, 12, 11', 12') sont alternativement électriquement reliées aux couches d'électrodes intérieures (3, 4).

3. Procédé selon la revendication 1 ou 2, dans lequel les tranchées (7, 8) présentent une profondeur (T), une largeur (b) et/ou une hauteur (h) qui sont exactement nécessaires pour une isolation électrique des couches d'électrodes intérieures (3, 4) par rapport à l'électrode extérieure correspondante (11, 12).

4. Procédé selon les revendications 1 à 3, dans lequel les tranchées (7, 8) sont réalisées par enlèvement sélectif au laser.

5. Actionneur piézoélectrique avec un empilement piézoélectrique (1", 1"') et deux électrodes extérieures agencées contre le côté extérieur (5) de l'empilement piézoélectrique (1", 1"'), qui a été fabriqué avec le procédé selon l'une des revendications 1 à 4.
